(19) Europäisches Patentamt / European Patent Office / Office européen des brevets

(11) **EP 3 086 207 B1**

(12) **EUROPEAN PATENT SPECIFICATION**

(45) Date of publication and mention
of the grant of the patent:
**17.04.2019 Bulletin 2019/16**

(21) Application number: **14872063.4**

(22) Date of filing: **28.10.2014**

(51) Int Cl.:
*G06F 3/01* (2006.01)     *G06F 3/041* (2006.01)
*H01L 41/09* (2006.01)    *B60K 35/00* (2006.01)
*G06F 3/0354* (2013.01)   *B06B 1/06* (2006.01)
*B06B 1/14* (2006.01)

(86) International application number:
**PCT/JP2014/005451**

(87) International publication number:
**WO 2015/092966 (25.06.2015 Gazette 2015/25)**

(54) **ELECTRONIC DEVICE FOR GENERATING VIBRATIONS**

ELEKTRONISCHE VORRICHTUNG ZUR ERZEUGUNG VON VIBRATIONEN

DISPOSITIF ÉLECTRONIQUE POUR GÉNÉRER DES VIBRATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2013 JP 2013260829**

(43) Date of publication of application:
**26.10.2016 Bulletin 2016/43**

(73) Proprietor: **Panasonic Intellectual Property Management Co., Ltd.**
**Osaka-shi, Osaka 540-6207 (JP)**

(72) Inventor: **MURAMATSU, Fumio**
**Osaka-shi, Osaka 540-6207 (JP)**

(74) Representative: **Grünecker Patent- und Rechtsanwälte**
**PartG mbB**
**Leopoldstraße 4**
**80802 München (DE)**

(56) References cited:
WO-A1-2013/073234    JP-A- 2009 131 740
JP-U- 3 085 481       US-A1- 2009 244 017
US-A1- 2010 238 132   US-A1- 2011 032 091
US-A1- 2011 057 888   US-A1- 2012 026 103
US-A1- 2013 229 088   US-A1- 2013 328 447

**Description**

## TECHNICAL FIELD

The present disclosure relates to an electronic device which generates vibration in accordance with a touch operation by a user.

## BACKGROUND ART

Electronic devices including a touch panel have come into practical use. Through touch panel manipulation, however, it is difficult for the user to appreciate a feel of the input manipulation, and thus the user may inadvertently make unintended touch inputs. With a view to improving the manipulability of touch inputs, techniques are known for giving a haptic sensation to the user by vibrating the touch panel. By applying a voltage to a vibrating section which is provided on a touch panel, a vibration is generated on the touch panel, thus allowing the user to experience a haptic sensation (see, for example, Patent Document 1). From the haptic sensation, the user is able to know whether an input to the electronic device has been completed through touch panel manipulation, whereby stable inputting is realized. US 2011/057 888 A1 and US 2011/032 091 A1 relate to a touch screen device. US 2013/229 088 A1 relates to a haptic module using a piezoelectric element.

## CITATION LIST

### PATENT LITERATURE

[Patent Document 1] Japanese Laid-Open Patent Publication No. 4-199416

## SUMMARY

### TECHNICAL PROBLEM

The present disclosure provides an electronic device which is able to stably present vibrations to a user in accordance with touch operations.

### SOLUTION TO PROBLEM

An electronic device according to the present disclosure is defined in claim 1. Further advantageous embodiments are defined in the dependent claims.

### ADVANTAGEOUS EFFECTS

In one embodiment of the present disclosure, there is provided an electronic device which, even in the case of a highly rigid panel, produces a sufficient vibration amplitude at a low frequency (e.g. around 100 Hz). In one embodiment of the present disclosure, there is provided an electronic device which reduces discrepancies in haptic sensation that are associated with different touched positions on a touch operation plane.

### BRIEF DESCRIPTION OF DRAWINGS

[FIG. **1**] A diagram showing an electronic device according to Embodiment 1.
[FIG. **2**] A diagram showing a touch panel unit according to Embodiment 1.
[FIG. **3**] **(a)** to **(d)** are diagrams describing flexural vibration that is caused in a diaphragm by a piezoelectric element according to Embodiment 1.
[FIG. **4**] **(a)** and **(b)** are diagrams describing vibrations of a touch panel unit according to Embodiment 1.
[FIG. **5**] A diagram showing a touch panel unit according to Embodiment 1.
[FIG. **6**] A diagram showing positions on a diaphragm at which piezoelectric elements and weight pieces are mounted according to Embodiment 2.
[FIG. **7**] A diagram showing how a weight piece may be mounted on a diaphragm according to Embodiment 2.
[FIG. **8**] A diagram showing positions on a diaphragm at which piezoelectric elements and weight pieces are mounted according to Embodiment 2.

[FIG. **9**] A diagram showing a diaphragm according to Embodiment 3.

[FIG. **10**] A diagram showing a touch panel unit.

## DESCRIPTION OF EMBODIMENTS

Embodiments will now be described in detail, referring to the drawings. Note however that unnecessarily detailed descriptions may be omitted. For example, detailed descriptions on what is well known in the art or redundant descriptions on what is substantially the same constitution may be omitted. This is to avoid lengthy description, and facilitate the understanding of those skilled in the art.

The accompanying drawings and the following description, which are provided by the present inventors so that those skilled in the art can sufficiently understand the present disclosure, are not intended to limit the scope of claims.

First, problems associated with an electronic device which gives a haptic sensation to a user by vibrating a touch panel will be described.

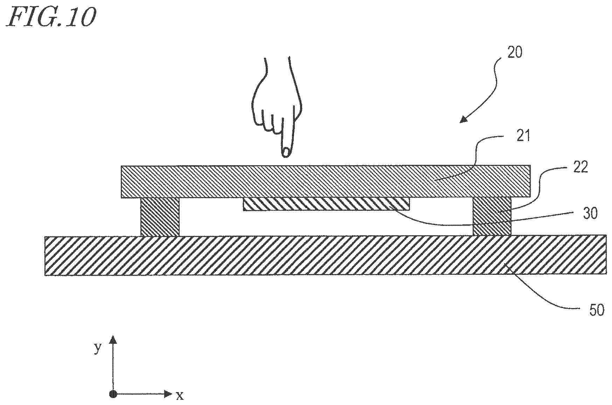

FIG. **10** is a diagram schematically showing a touch panel unit **20**. As shown in FIG. **10**, a vibrating section **30** to induce vibration of the touch panel **21** is attached to the touch panel **21**. The vibrating section **30** is a piezoelectric element, for example. Although the vibrating section **30** is usually mounted on a face of the touch panel **21** that will not be touched by the user, the vibrating section **30** may alternatively be mounted on a face that the user will be touching. The touch panel **21** is supported by fixture portions **22**, the fixture portions **22** being fixed to a base **50**. The method of fixing the touch panel **21** may be arbitrary, such as screwing or adhesive bonding.

As a voltage is applied to the vibrating section **30** attached to the touch panel **21** so as to cause the touch panel **21** to vibrate, the touch panel unit **20** is able to give a haptic sensation to the user. Thus, from the haptic sensation, the user is able to know whether or not an input to the electronic device has been completed through touch panel manipulation, whereby stable inputting is realized.

In some cases, however, the construction of the touch panel unit **20** shown in FIG. **10** may not be able to present a haptic sensation of a sufficient intensity to the user. The reasons are as follows.

In order to induce substantial vibration in the touch panel **21** with vibration of the vibrating section **30**, it would be efficient to utilize a resonance phenomenon. Generally speaking a touch operation plane of the touch panel **21** has a planar shape; however, from the standpoints of ease of use, aesthetic design, or the like, the touch panel **21** may also be shaped to present a curved surface. Example shapes may be those in which the central portion of the touch panel **21** is dented or rises toward the user's touch surface relative to the ends. Moreover, the touch panel **21** may have some ornamental members mounted thereon. In such cases, the touch panel **21** has an improved rigidity, thus resulting in a higher resonant frequency of flexural vibration than that of a touch panel **21** of a planar shape that is made in substantially the same dimensions and same material.

Moreover, the touch panel **21** is a member that will be touched by the user. From safety standpoints, the touch panel **21** is expected not to break up and scatter when a person collides against it in an unpredictable accident or the like. Thus, the touch panel **21** has a certain thickness or greater. When having a large thickness, the touch panel **21** attains an improved rigidity, and its resonant frequency of flexural vibration becomes higher than that of a touch panel **21** with a small thickness that is made in substantially the same dimensions and same material.

If the touch panel **21** has a high vibration frequency, the vibration may feel so sharp as to be unpleasant to the user, feel like an alarm, or otherwise disliked. Moreover, a person is unlikely to perceive any vibration of a certain frequency or greater. For use with haptic sensation presentation, it may be preferable that the vibration of the touch panel **21** is around 100 Hz. Unlike that of a planar shape, a touch panel **21** that is shaped to present a curved surface (such as a flexed shape) may have a resonant frequency of flexural vibration which is several times the frequency of the former, thus making it difficult to efficiently utilize the resonance phenomenon.

If the resonance phenomenon cannot be utilized, then, a multitude of vibrating sections **30** might be attached to the touch panel **21** to ensure intense vibration at around 100 Hz. However, there exists a thin film for touch-detecting purposes attached on the rear face of the touch panel **21**, upon which no vibrating sections **30** can be attached. This makes it difficult to attach a multitude of vibrating sections **30** on the touch panel **21**. The reason why vibrating sections **30** cannot be attached on the film for touch-detecting purposes is that a high voltage of several dozen volts to be applied to the vibrating sections **30** may lead to misdetections of touched positions on the touch panel **21**, or that vibrations of the vibrating sections **30** may not adequately propagate to the panel surface even if piezoelectric elements are attached on the thin and soft film. In other words, it is difficult for a highly-rigid touch panel **21** to attain sufficient vibration amplitude at a frequency as low as around 100 Hz. Moreover, in the case where piezoelectric elements are used, there is an additional problem in that stronger or weaker vibrations may result depending on the place of the touch panel **21** that is touched by the user, because according to natural, principles the touch panel **21** undergoes flexural vibration.

In one embodiment of the present disclosure, there is provided an electronic device which provides sufficient vibration amplitude at a low frequency (around 100 Hz) even if its touch panel is highly rigid. In one embodiment of the present disclosure, there is provided an electronic device which reduces discrepancies in haptic sensation that are associated with different touched positions on a touch operation plane.

(Embodiment 1)

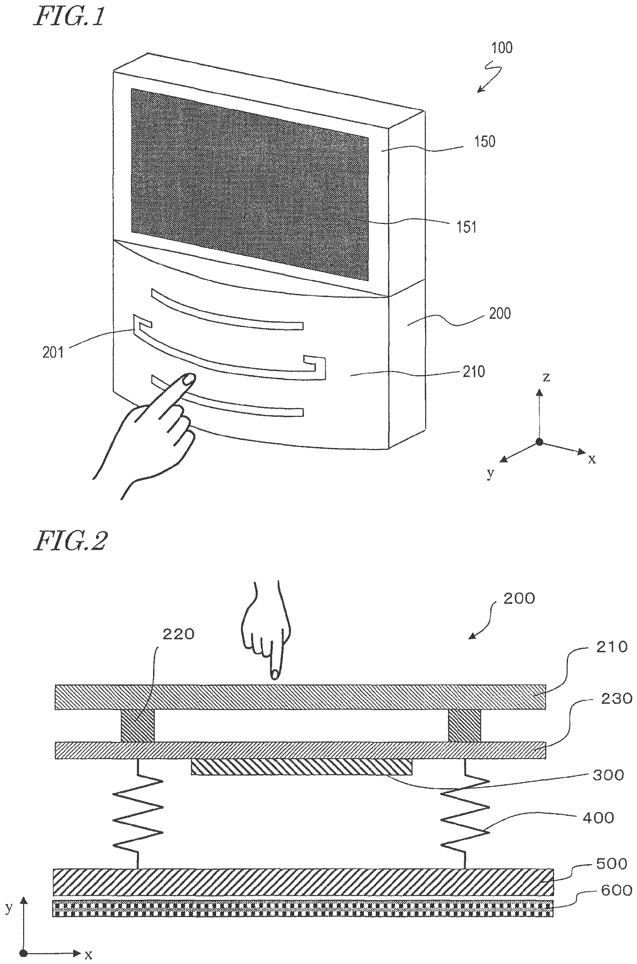

Hereinafter, Embodiment 1 will be described with reference to FIGS. **1** to **4**.

[1-1. Construction]

FIG. **1** is a perspective view showing the appearance of an electronic device **100** according to Embodiment 1. The electronic device **100** is a device which can be touch-manipulated by a user, e.g., a car navigation system, a smartphone, or a pad-type computer.

FIG. **1** shows a car navigation system as an example of the electronic device **100**. The electronic device **100** shown in FIG. **1** includes a display unit **150** and a touch panel unit **200**.

In an image displaying region **151** of the display unit **150**, image information, e.g., a map, is mainly displayed. The touch panel unit **200** is an interface which accepts various commands from the user to the electronic device **100**. In the case where the touch panel unit **200** includes a display device, manipulation acceptors such as various buttons will be displayed on the touch panel unit **200**, and the user will touch on the indicated display acceptors in order to manipulate the electronic device **100**. Note that the touch panel unit **200** may lack a display device. Moreover, the display unit **150** may be a touch display unit that includes a touch panel to accept touch operations by the user, in which case the user will be able to render touch operations on both the display unit **150** and the touch panel unit **200**.

In the display unit **150** and in the touch panel unit **200**, physical buttons may be partially or entirely omitted in order to broaden the image displaying region **151**, improve interface freedom, or improve on the aesthetic design. On the other hand, a car navigation system may be manipulated while an automobile is being driven, in which case one may not be able to gaze at the manipulating hands or the manipulation results. In order to provide feedback to the user that a manipulation has been accepted even in such cases, the electronic device **100** has a feedback function through haptic sensation based on panel vibration. Although it is the touch panel unit **200** that possesses the feedback function through haptic sensation based on vibration, the display unit **150** may also possess a feedback function through haptic sensation based on vibration.

In the example of FIG. **1**, the touch operation plane of the touch panel **210** is shaped so as to present a curved surface. For example, the touch panel **210** is shaped so that its central portion is dented or rises toward the user's touch operation plane relative to the end shapes.

Moreover, for an improved aesthetic design, an ornament **201** may be provided on the touch panel **210** of the touch panel unit **200**. In the case where the ornament **201** has a contoured shape, e.g., a protruding shape, the user may be able to utilize the ornament **201** as a reference position (e.g., a home position) in making touch operations.

FIG. **2** schematically shows a construction of the touch panel unit **200** according to Embodiment 1.

The touch panel unit **200** includes the touch panel **210**, support portions **220**, a vibration transmitting section **230**, a vibrating section **300**, elastic pieces **400**, a base **500**, and a control section **600**.

The touch panel **210** is a panel which is touched by the user to manipulate the touch panel unit **200**, or provides feedback to the user by presenting a haptic sensation which is in accordance with the manipulation. Although the example of FIG. **2** illustrates a flat-shaped touch panel **210** for ease of understanding, the touch panel **210** may alternatively be shaped to present a curved surface as has been mentioned earlier.

In this example, the vibration transmitting section **230** is a diaphragm, which is disposed on the opposite side of the touch panel **210** from the side to be touched by the user, at an interval from the touch panel **210**. The diaphragm **230** is coupled to the touch panel **210** via the support portions **220**. The touch panel **210** and the diaphragm **230** are not of a construction such that they are completely integral, as they would be in the case of being adhesively bonded over the entire surface. In this example, a space is created between the touch panel **210** and the diaphragm **230**. The material of the diaphragm **230** may be aluminum or an iron-based metal, a resin-type material, or the like, and a material with a low rigidity to allow it to curve under an external force is to be used. As the method of coupling between the support portions **220**, the diaphragm **230**, and the touch panel **210**, screwing or adhesive bonding is used, but any other method may be used. The touch panel **210** and the support portions **220** may be formed as an integral piece, or the diaphragm **230** and the support portions **220** may be formed as an integral piece.

The vibrating section **300** is mounted on the diaphragm **230**. The vibrating section **300** is an actuator that induces flexural vibration in the diaphragm **230**. The vibrating section **300** may be a piezoelectric element or a rotary vibration motor, for example. Installation of the vibrating section **300** to the diaphragm **230** may be achieved with the use of an adhesive, a double-coated adhesive tape, or by screwing, etc. Although the vibrating section **300** is to be mounted on the opposite face of the diaphragm **230** from the touch panel **210** as shown in FIG. **2**, it may instead be mounted on the face that is proximate to the touch panel **210**.

The elastic pieces **400** are mounted between the diaphragm **230** and the base **500**. The elastic pieces **400** are connected to the opposite side of the diaphragm **230** from the touch panel **210**, to elastically support the touch panel **210**, the support portions **220**, the diaphragm **230**, and the vibrating section **300**. The elastic pieces **400** are members that bear the masses of the touch panel **210**, the support portions **220**, the diaphragm **230**, and the vibrating section **300**, to generate vibration of a so-called spring-mass system. Since it is intended that flexural vibration of the vibrating section **300** induces spring oscillation in the elastic pieces **400**, the positions at which to mount the elastic pieces **400** are not limited to between the diaphragm **203** and the base **500**. The elastic pieces **400** may be any members that have elasticity, e.g., rubber washers; alternatively, they may also be springs or the like.

The base **500** is a housing of the electronic device **100** in which component elements of the touch panel unit **200** are to be accommodated. The base **500** is coupled to and supports the elastic pieces **400**. An example of the base **500** is the housing of a car navigation system. Note that the base **500** does not need to be a component element of the electronic device **100**, but may be an external member on which the electronic device **100** is to be mounted. For example, the base **500** may be a member of a vehicle body in which the car navigation system is to be installed.

The control section **600** is a control circuit to control the operation of the touch panel unit **200**, and performs various controls and determinations. The control section **600** includes a microcomputer and a memory, for example, such that the microcomputer operates on the basis of a computer program which is read from the memory. The control section **600** may be included in the touch panel unit **200**, or provided in a device which is external to the touch panel unit **200** so as to externally control the operation of the touch panel unit **200**.

[1-2. Operation]

An operation of the touch panel unit **200** as above will be described in details below.

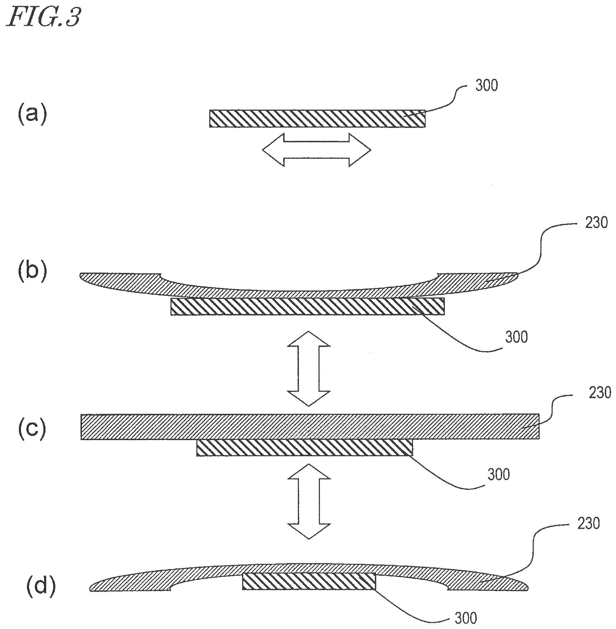

FIG. **3(a)** to FIG. **3(d)** are diagrams describing how the diaphragm **230** may vibrate in the case where a piezoelectric element is used as an exemplary vibrating section **300**. Hereinafter, when illustrating manners of vibration in the figures, a vibration which is above the actual vibration amplitude may occasionally be illustrated for ease of understanding. A piezoelectric element **300** is an electromechanical transducer which expands in one direction with a voltage application between its electrodes (not shown), and contracts under a voltage whose positive or negative polarity is inverted (FIG. **3(a)**).

In a construction where the piezoelectric element **300** is attached on the diaphragm **230,** when the piezoelectric element **300** is not expanded or contracted, the touch panel maintains its original shape (e.g., a flat shape)(FIG. **3(c)**). When the piezoelectric element **300** expands, the diaphragm **230** becomes more dented than its original shape (FIG. **3(b)**). When the piezoelectric element **300** contracts, the diaphragm **230** becomes more protruding than its original shape (FIG. **3(d)**). When a sine-wave voltage is applied between the electrodes of the piezoelectric element **300**, for example, the piezoelectric element **300** undergoes repetitive expansion and contraction. As the piezoelectric element **300** repeats expansion and contraction, flexural vibration is induced in the diaphragm **230** (FIG. **3(b)** to FIG. **3(d)**).

The magnitude of the voltage to be applied between the electrode of the piezoelectric element **300** and the amount of expansion and contraction of the piezoelectric element **300** are in proportion, and also the amount of expansion and contraction of the piezoelectric element **300** and the amplitude of flexural vibration of the diaphragm **230** are in proportion. Therefore, by adjusting the magnitude of the voltage to be applied to the piezoelectric element **300**, it is possible to adjust the vibration amplitude of the diaphragm **230**.

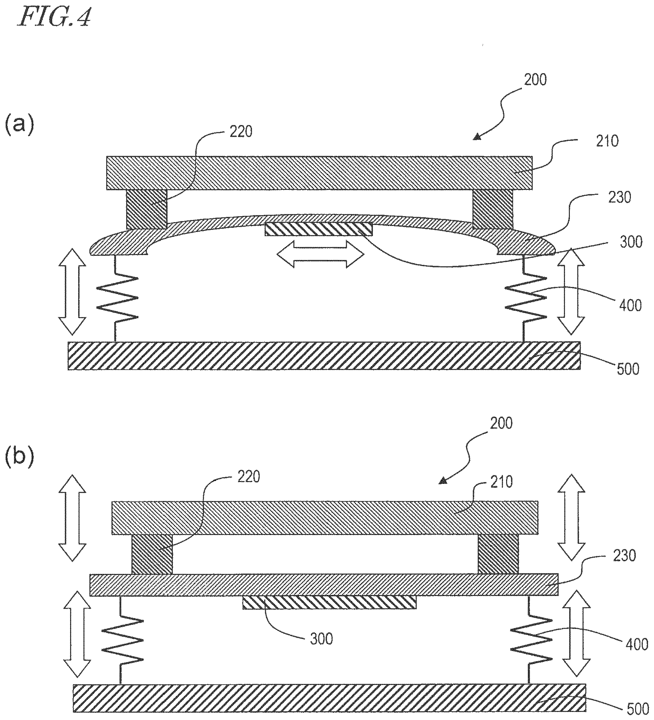

FIG. **4** shows how vibration may propagate to the user with the touch panel unit **200**. A construction for realizing a feedback function through haptic sensation to propagate vibration to the user will be described below.

The touch panel **210** detects the presence or absence of a user touch, the touched position, the number of touching fingers, the motion of the touching finger(s), and so on. Based on the information of the user's touch operation as detected by the touch panel **210**, the control section **600** generates a driving instruction to drive the vibrating section **300**, and outputs it to the vibrating section **300**. The vibrating section **300** vibrates in accordance with the driving instruction, and this vibration propagates to the touch panel, whereby a haptic sensation is presented to the user that is touching the touch panel.

As has been described with reference to FIG. **3**, when a sine-wave voltage is applied between the electrodes of the piezoelectric element **300**, the piezoelectric element **300** undergoes expansion and contraction. With the expansion and contraction of the piezoelectric element **300**, flexural vibration is induced in the diaphragm **230** (FIG. **4(a)**). The diaphragm **230** is disposed with a gap from the touch panel **210**. Therefore, rigidity of the touch panel **210** does not restrain flexural vibration, and the diaphragm **230** is allowed to flex with a large vibration amplitude. Moreover, since the diaphragm **230** is in the interior of the electronic device **100**, it permits more design freedom, e.g., being made into a planar shape or reduced in thickness, than does the touch panel **210**. As a result, it is easy to create a design that sets the resonant frequency of the diaphragm **230** to a desired frequency, e.g. around 100 Hz. For example, the resonant frequency of the diaphragm **230** is set between 50 Hz and 200 Hz. More desirably, the resonant frequency is set between 80 Hz and 150 Hz. The reason why around 100 Hz is exemplified as a desired frequency is that, while the frequencies that are perceptible to humans are 300 Hz or less, the haptic sensation may turn out painful or be perceived as if an alarm at any frequency above 200 Hz. On the other hand, vibration of any frequency that is far below 100 Hz, e.g., vibration of less than 50 Hz, is unlikely to be communicated to humans. By causing resonance in the diaphragm **230**, the diaphragm **230** undergoes flexural vibration with a large amplitude. This flexural vibration propagates to the elastic pieces **400** that are coupled to the diaphragm **230**, thereby vibrating the elastic pieces **400** (FIG. **4(a)**). At this time, the touch panel **210** supported by the elastic pieces **400** will also vibrate along with the elastic pieces **400**, whereby the vibration is communicated to the user.

The elastic pieces **400** bear the masses of the touch panel **210**, the support portions **220**, the diaphragm **230**, and the piezoelectric element **300**, thus establishing a so-called spring-mass system. By appropriately designing the masses of the component elements that are supported by the elastic pieces **400** and the spring moduli of the elastic pieces **400**, the resonant frequency of this spring-mass system can also be set to a desired frequency (e.g. around 100 Hz). In other words, the resonant frequency of the diaphragm **230** and the resonant frequency of the spring-mass system vibration can be equally set around 100 Hz.

As described earlier, in the touch panel unit **200** of the present embodiment, the diaphragm **230** is disposed with a gap from the touch panel **210**. As a result, even if the touch panel **210** is highly rigid, flexural vibration of the diaphragm **230** is not restrained and the diaphragm **230** is allowed to flex with a large vibration amplitude.

Moreover, by utilizing resonance of the flexural vibration and resonance of the spring-mass system, and equalizing their frequencies, it becomes possible to efficiently induce vibration in the touch panel **210**. It is desirable that the intensity of the vibration to be induced in the touch panel **210** exceeds 2.5 G as translated into acceleration. Note that 2.5 G defines an intensity that allows the vibration to be perceived even when the touch panel **210** is touched in an automobile during travel.

Moreover, the touch panel **210** affects vibration only as a mass, while its shape and rigidity do not affect vibration. Thus, even when shaped so as to have a high rigidity, the touch panel **210** can still present a sufficient haptic sensation.

Furthermore, since the touch panel **210** is subject to the vibration of the spring-mass system and uniformly vibrates in the up-down direction as shown in FIG. **4(a)** and FIG. **4(b)**, the intensity of vibration on the touch operation plane of the touch panel **210** can be made essentially uniform, thereby reducing discrepancies in haptic sensation that are associated with different touched positions on the touch operation plane.

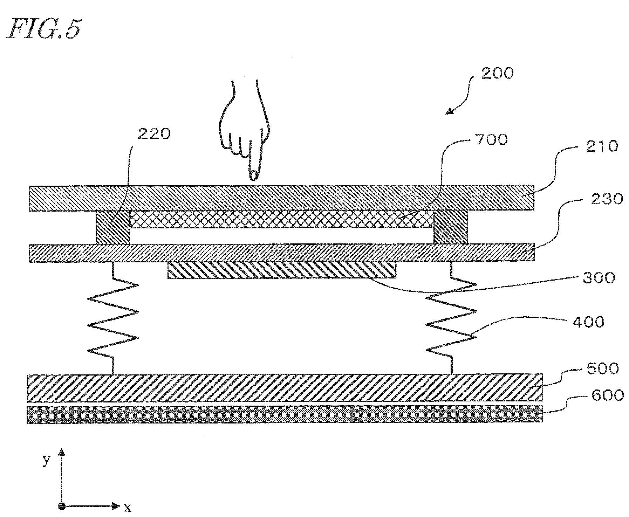

Note that, as shown in FIG. **5**, the touch panel unit **200** may include a display device **700** which displays an image. The display device **700** is to be provided on the opposite face of the touch panel **210** from the touch operation plane, for example. In this case, too, the diaphragm **230** is disposed with a gap from the display device **700**. Therefore, even if the display device **700** is highly rigid, flexural vibration of the diaphragm **230** is not restrained, and the diaphragm **230** is allowed to flex with a large vibration amplitude. Moreover, this makes it easy to set the resonant frequency of the diaphragm **230** to a desired frequency (e.g. around 100 Hz).

Note that the touch panel **210** and the display device **700** may be formed as an integral piece. For example, the touch panel **210** may be an in-cell type touch panel where the touch panel function is integrated inside the liquid crystal panel, an on-cell type touch panel where the touch panel function is integrated on the surface of a liquid crystal panel, or the like. Moreover, the touch panel **210** may be a touch-sensored display panel that is shaped to present a curved surface, e.g., a curved display, or a touch-sensored display panel that is capable of deformation, e.g., a flexible display. In these cases, too, the diaphragm **230** is disposed with a gap from the touch panel **210**, so that flexural vibration of the diaphragm **230** is not restrained, and the diaphragm **230** is allowed to flex with a large vibration amplitude. Moreover, this makes it easy to set the resonant frequency of the diaphragm **230** to a desired frequency (e.g. around 100 Hz).

(Embodiment 2)

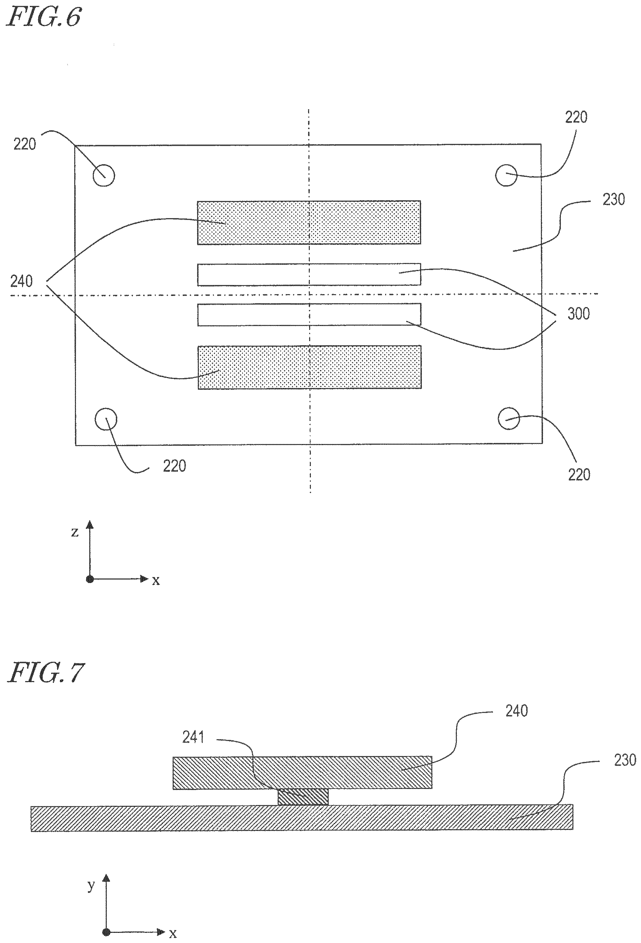

Next, with reference to FIG. **6** to FIG. **8**, an electronic device **100** according to Embodiment 2 will be described. FIG. **6** is a plan view schematically showing a diaphragm **230** of the electronic device **100** according to Embodiment 2. Supports **220** for providing support to the touch panel **210** are formed on the diaphragm **230**. Moreover, weight pieces **240** and piezoelectric elements **300** are mounted on the diaphragm **230**. The diaphragm **230** has a shape which leads to low rigidity, so that, for example, the $0^{th}$ mode resonance of flexure is around 100 Hz. For example, the diaphragm **230** has a substantially planar shape with minimum protrusions or the like, with a small plate thickness.

The support portions **220** are members that connect the diaphragm **230** and the touch panel **210**. The support portions **220** of the diaphragm **230** may be apertures, for example, and by way of threaded holes formed at the support portions **220** on the touch panel **210** side, the diaphragm **230** and the touch panel **210** may be screwed together. The positions of the support portions **220** to be connected to the touch panel **210** define nodes of the vibration of the diaphragm **230**. There exist many such vibration modes, e.g., $0^{th}$ order, $1^{st}$ order, and $2_{nd}$ order, where lower-order modes correspond to lower frequencies. A diaphragm **230** of a size which is intended for a generic car navigation system tends to exceed 100 Hz even at the $0^{th}$ mode. Given the positions of the support portions **220** defining the nodes, and the central vicinity of the diaphragm **230** along the longer side defining an antinode, in order to decrease the $0^{th}$ mode resonant frequency of this flexural vibration to around 100 Hz, the support portions **220** may need to be provided as much outward on the diaphragm **230** as possible.

The weight pieces **240** are members for increasing the mass of the spring-mass system to adjust the resonant frequency to around 100 Hz. Since the resonant frequency of the spring-mass system is expressed by eq. (2.1), the resonant frequency can be decreased by introducing an increased mass with the weight pieces **240**. Examples of the material of the weight pieces **240** include iron-based materials and brass; however, any other metal or resin-type material may also be used.

[math. 1]

$$f = \frac{1}{2\pi}\sqrt{\frac{k}{m}} \qquad f : \text{resonant frequency}\,[Hz]、\quad k : \text{spring modulus}\,[N/m]、\quad m : \text{mass}\,[kg] \qquad\qquad \text{eq.(2.1)}$$

The piezoelectric elements **300** are vibration sources which induce flexural vibration in the diaphragm **230.** The piezoelectric elements **300** are in positions that are closer to the antinode than to the nodes of the vibration of the diaphragm **230**. In this example, the piezoelectric elements **300** are in positions that are closer to the center, than to the ends, of the diaphragm **230**. For example, the piezoelectric elements **300** may be attached in the central vicinity of the diaphragm **230.** The reasons are as follows.

Regarding resonance of any flexural vibration occurring in the diaphragm **230**, the lowest frequency happens in a so-called 0th mode vibration, with its antinode defined at the center along the longer side and nodes defined at the positions of the support portions **220**, which does not exhibit any vibration distribution along the shorter side. In order to ensure a greater 0th mode amplitude, it is desirable for the piezoelectric elements **300** to be mounted in the center along the longer side of the diaphragm **230**, i.e., at the antinode position of the 0th mode vibration. Along the shorter side, too, the piezoelectric elements **300** are to be mounted in the central vicinity, where vibration is easier to occur than at the upper side and the lower side because of not being restrained by the support portions **220.** For example, if two piezoelectric elements **300** are to be mounted as shown in FIG. **6,** they may be mounted in the essential center of the diaphragm **230**.

Next, with reference to FIG. **7**, an exemplary shape of a weight piece **240** will be described. Each weight piece **240** is a member for decreasing the resonant frequency of the spring-mass system to around 100 Hz. A support portion **241** is formed on the weight piece **240**, and, as the support portion **241** is connected to the diaphragm **230**, the weight piece **240** and the diaphragm **230** become coupled. The area in which the support portion **241** is in contact with the diaphragm **230** is smaller than an area occupied by the weight piece **240** at the diaphragm **230** side.

Moreover, the weight pieces **240** are in positions that are closer to the antinode than to the nodes of the vibration of the diaphragm **230**. In this example, the weight pieces **240** is disposed in positions that are closer to the center, than to the ends, of the diaphragm **230**. For example, the weight pieces **240** may be mounted in the central vicinity along the longer side of the diaphragm **230**.

In this example, in order not to allow the rigidity of the diaphragm **230** to increase, the area of contact between each weight piece **240** and the diaphragm **230** is kept small. The reasons are as follows.

If the entire surface of each weight piece **240** is directly mounted on the diaphragm **230**, i.e., not by way of the support portion **241**, the diaphragm **230** will increase in rigidity, and the resonant frequency of flexural vibration will be much greater than 100 Hz, thus hindering an efficient use of resonance. Therefore, in order to prevent an increase in rigidity of the diaphragm **230** while allowing the weight pieces **240** to introduce an increased mass in the spring-mass system, it is necessary that the weight pieces **240** be mounted in places where they do not hinder flexural vibration of the diaphragm **230**. In order to prevent hindrance of vibration of the diaphragm **230**, the weight pieces **240** are disposed in the antinode position of vibration, and their areas of contact with the diaphragm **230** are kept as small as possible. Note that the method of mounting the support portions **241** on the diaphragm **230** may be arbitrary; for example, screwing or adhesive bonding may be used. Moreover, the weight pieces **240** and the support portions **241** may be separate members which may be fixed together by any arbitrary method, e.g., screwing or adhesive bonding.

By attaching the piezoelectric elements **300** in the central vicinity of the diaphragm **230** as shown in FIG. **6** and FIG. **7** and optimizing the positions at which the weight pieces **240** are mounted, more intense vibration can be induced in the touch panel **210**.

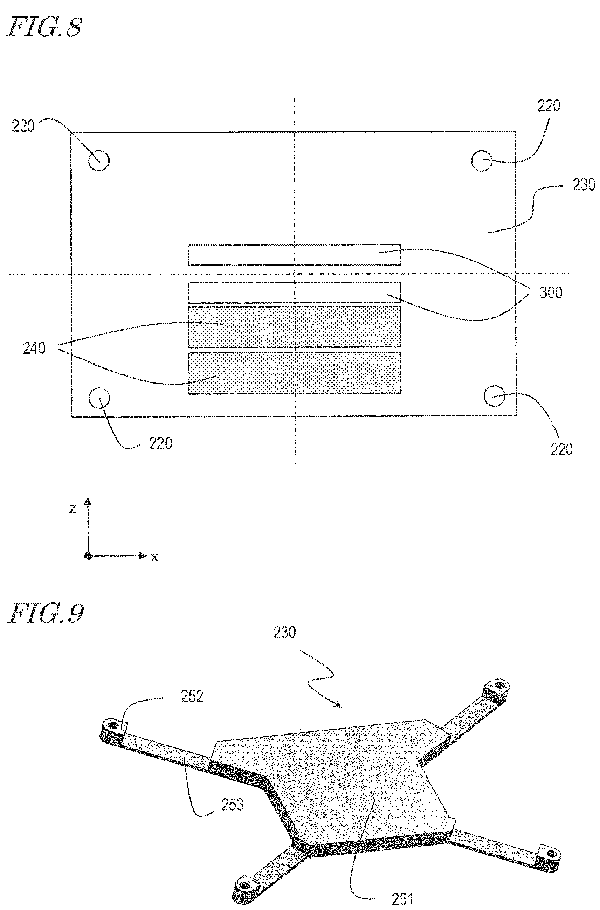

FIG. **8** shows another example of positions on the diaphragm **230** to attach the weight pieces **240**. The support portions **220** and the piezoelectric elements **300** are similar to those in the example of FIG. **6**.

In the example of FIG. **8**, the weight pieces **240** are disposed in a vicinity where an increase in the vibration amplitude of the touch panel **210** is desired. The reasons are as follows.

As has been described with reference to FIG. **4**, the touch panel **210** vibrates essentially uniformly across its entirety. However, when there is an extreme inequality in the weight distribution of the touch panel **210** for reasons of aesthetic design or the like, for example, vibration of the touch panel **210** will be non-uniform from position to position. Even in such cases, uniformity in vibration amplitude of the touch panel **210** can be ensured by adjusting the positions on the diaphragm **230** at which to mount the weight pieces **240**. Specifically, by allowing the weight pieces **240** to be disposed in a place where an increase in the vibration amplitude of the touch panel **210** is desired, the inertial force is increased, and so is the amplitude. For example, to attain an improved vibration amplitude in the lower portion of the touch panel **210**, the weight pieces **240** may be mounted closer to the lower side of the diaphragm **230**, as shown in FIG. **8.**

By offsetting the positions at which to mount the weight pieces **240** away from the center as shown in FIG. **8**, it becomes possible to enhance vibration of the touch panel **210** at places closer to where the weight pieces **240** have been shifted.

(Embodiment 3)

Next, with reference to FIG. **9**, an electronic device **100** according to Embodiment 3 will be described. FIG. **9** is a perspective view schematically showing a diaphragm **230** of the electronic device **100** of Embodiment 3.

In Embodiments 1 and 2, the vibration transmitting section **230** is described as a diaphragm; in the present embodiment, the vibration transmitting section **230** includes weight pieces **251**, support portions **252**, and arms **253**. In the present embodiment, the piezoelectric elements **300** are attached to the arms **253**. Although the material of the vibration transmitting section **230** is an iron-based metal or aluminum, for example, any other metal or resin-type material may also be used.

The weight pieces **251**, which define places where weight adjustments are made so that the spring-mass system has a resonant frequency of around 100 Hz, are heavier than the arms **253**. Masses of the weight pieces **251** are adjusted mainly by increasing or decreasing their thickness, whereby the resonant frequency of the spring-mass system is set around 100 Hz. Since the weight pieces **251** are thick and highly rigid, flexural vibration hardly occurs in the weight pieces **251** at around 100 Hz.

Via the support portions **220** of the touch panel **210,** the support portions **252** couple the vibration transmitting section **230** and the touch panel **210** together. Apertures are made in the support portions **252,** and screwing is performed by way of threaded holes formed at the support portions **220** on the touch panel **210;** however, other methods of coupling may also be employed.

The arms **253** are fixed to the support portions **252,** and support the weight pieces **251.** The arms **253** couple the weight pieces **251** and the support portions **252** together, and define places where a flexural resonance around **100** Hz is to be caused in the vibration transmitting section **230.** By ensuring that the arms **253** are both thin and narrow, flexural vibration can be caused at a frequency as low as around 100 Hz. Each piezoelectric element **300** is provided on an arm **253** so that at least a portion thereof overlaps the arm **253.** As the piezoelectric elements **300** undergo expansion and contraction, flexural vibration at a frequency as low as around 100 Hz can be caused in the arms **253.**

By constructing the vibration transmitting section **230** as shown in FIG. **9**, the resonant frequency of flexural vibration of the vibration transmitting section **230** and the resonant frequency of the spring-mass system can both be set around 100 Hz, without separately using any members such as the weight pieces **240** (FIG. **6** to FIG. **8**); as a result, more intense vibration can be induced in the touch panel **210**. Effects similar to those described in Embodiments 1 and 2 above are obtained by using the vibration transmitting section **230** according to the present embodiment.

(Other embodiments)

In the above, Embodiments 1 to 3 have been described as an example of the technique disclosed in the present application. However, the technique of the present disclosure is not limited thereto, but is also applicable to other embodiments in which changes, substitutions, additions, omissions, etc., are made as necessary. Different ones of the elements described in Embodiments 1 to 3 above may be combined together to obtain a new embodiment.

Other embodiments will be illustrated hereinbelow.

Although the above embodiments are directed to a car navigation system as an example of an electronic device, the electronic device is not limited thereto. For example, it may be any electronic device that includes a touch panel, e.g., an information terminal device of a tablet type, a mobile phone, a PDA, a game machine, or an ATM. Moreover, the electronic device may be a pointing device such as a mouse. The electronic device may also be a touch pad.

Although the above embodiments illustrate "around 100 Hz" as an example resonant frequency of flexural vibration of the vibration transmitting section and of the spring-mass system, it may be any other frequency.

Although the above embodiments illustrate piezoelectric elements as vibrating sections, this is not a limitation. Electrostatic force-based actuators, VCMs, vibration motors, or the like may also be used. Moreover, transparent piezoelectric members in the form of thin films may be formed on the vibration transmitting member by sputtering or other methods, so as to be used as vibrating sections.

Although the above embodiments illustrate flexural vibration as an example type of vibration, it may be any other vibration.

Although a haptic sensation is presented by generating vibration in the above-described embodiment, the technique of the present disclosure is not limited thereto. Other than vibration, haptic sensations may be presented by other methods, e.g., as a variation of friction associated with static electricity, a skin stimulation with an electric current, and a variation of the screen shape using liquid. In addition to presenting a haptic sensation, screen display, sounds, light, heat, etc., may be used in combination as necessary.

Note that the vibration operation control for an electronic device described above may be implemented by means of hardware or software. A program implementing such a control operation is stored, for example, in an internal memory of a microcomputer, or a ROM. Such a computer program may be installed onto the electronic device from a storage medium (an optical disc, a semiconductor memory, etc.) on which the computer program is recorded, or may be downloaded via a telecommunication lines such as the Internet.

(Summary)

Thus, as described above, an electronic device **100** according to an embodiment of the present disclosure includes: a panel **210** to be touched by a user; a vibration transmitting section **230** disposed at an interval from the panel **210**; a vibrating section **300** to vibrate the vibration transmitting section **230**; and an elastic member **400** elastically supporting the panel **210** and the vibration transmitting section **230**.

For example, the electronic device **100** may further include a base **500** supporting the elastic member **400**.

For example, vibration of the vibration transmitting section **230** may propagate to the elastic member **400** to vibrate the elastic member **400**, and cause the panel **210** supported by the elastic member **400** to vibrate.

For example, the resonant frequency of the vibration transmitting section **230** and the resonant frequency of spring-mass system vibration may be equal.

For example, the resonant frequency of the vibration transmitting section **230** may be 50 Hz to 200 Hz.

For example, at an interval from the panel **210**, the vibration transmitting section **230** may be disposed on the opposite side of the panel **210** from a side to be touched by the user; and the elastic member **400** may support the panel **210** and the vibration transmitting section **230** at the opposite side of the vibration transmitting section **230** from the panel **210**.

For example, the vibrating section **300** may be a piezoelectric element.

For example, the vibrating section **300** may be at a position closer to a central portion, than to ends, of the vibration transmitting section **230**.

For example, the vibrating section **300** may be at a position closer to an antinode, than to nodes, of vibration of the vibration transmitting section **230**.

For example, a weight piece **240** may be disposed at a position closer to a central portion, than to ends, of the vibration transmitting section **230**.

For example, a weight piece **240** may be disposed in a position closer to an antinode, than to nodes, of vibration of the vibration transmitting section **230**.

For example, the weight piece **240** may be in contact with the vibration transmitting section **230** in an area which is smaller than an area occupied by the weight piece **240** at the vibration transmitting section **230** side.

For example, the resonant frequency of spring-mass system vibration may be adjusted by the mass of the weight piece **240**.

For example, the vibration transmitting section **230** may include: a weight piece **251**; a support portion **252** coupling the panel **210** and the vibration transmitting section **230** together; and an arm **253** being fixed on the support portion **252** and supporting the weight piece **251**.

For example, the vibrating section **300** may be disposed on the arm **253**.

For example, the panel **210** may be shaped to present a curved surface.

For example, the electronic device **100** may be a touch panel **210** unit of a car navigation system.

For example, the electronic device **100** may further include a display section to display an image.

For example, the panel **210** may be an in-cell type touch panel.

For example, the panel **210** may be an on-cell type touch panel.

For example, the electronic device **100** may be a car navigation system.

Embodiments have been described above as an illustration of the technique of the present disclosure. The accompanying drawings and the detailed description are provided for this purpose. Thus, elements appearing in the accompanying drawings and the detailed description include not only those that are essential to solving the technical problems set forth herein, but also those that are not essential to solving the technical problems but are merely used to illustrate the technique disclosed herein. Therefore, those non-essential elements should not immediately be taken as being essential for the reason that they appear in the accompanying drawings and/or in the detailed description.

The embodiments above are for illustrating the technique disclosed herein, and various changes, substitutions, additions, omissions, etc., can be made without departing from the scope defined by the claims.

INDUSTRIAL APPLICABILITY

The technique according to the present disclosure is especially useful in the technological fields directed to electronic devices that generate vibrations in accordance with touch operations by a user.

REFERENCE SIGNS LIST

| 100 | electronic device |
| 150 | display unit |
| 151 | image displaying region |
| 200 | touch panel unit |
| 201 | ornament |
| 210 | touch panel |
| 220, 241, 252 | support portion |
| 230 | vibration transmitting section |
| 240, 251 | weight piece |
| 253 | arm |
| 300 | vibrating section |
| 400 | elastic piece |
| 500 | base |
| 600 | control section |
| 700 | display device |

Claims

1.  An electronic device (100) comprising:

a touch panel (210);
a vibration transmitting section (230) coupled to the touch panel (210) at an interval therefrom;
a vibrating section (300) to vibrate the vibration transmitting section (230);
an elastic member (400) elastically supporting the vibration transmitting section (230) and capable of vibrating responsive to vibration of the vibration transmitting section (230); and
a base (500) supporting the elastic member (400),
wherein the elastic member (400) is disposed between the vibration transmitting section (230) and the base (500) such that the touch panel (210) is supported by the elastic member (400) by way of the vibration transmitting section (230),
the electronic device further comprising a support portion (220, 241, 252) coupling the touch panel (210) and the vibration transmitting section (230) together,
the electronic device (100) being **characterized in that**
the elastic member (400) bears masses of the touch panel (210), the support portion, the vibration transmitting section (230) and the vibrating section (300) thereby establishing a spring-mass system, a resonant frequency of the vibration transmitting section (230) and a resonant frequency of the spring-mass system vibration are equal, a weight piece (240, 251) is disposed at a position closer to a central portion, than to ends, of the vibration transmitting section (230), and
the weight piece (240) is supported by a support portion (241) and connected to the vibration transmitting section (230) via the support portion (241), the support portion (241) is in contact with the vibration transmitting section (230) in an area which is smaller than an area occupied by the weight piece (240, 251) at the vibration transmitting section side.

2.  The electronic device of claim 1, wherein vibration of the vibration transmitting section (230) propagates to the elastic member (400) to vibrate the elastic member (400), and causes the touch panel (210) supported by the elastic member (400) to vibrate.

3.  The electronic device of claim 1 or 2, wherein a resonant frequency of the vibration transmitting section (230) is 50 Hz to 200 Hz.

**4.** The electronic device of any of claims 1 to 3, wherein,
at the interval from the touch panel (210), the vibration transmitting section (230) is disposed on an opposite side of the touch panel (210) from a side thereof to be touched; and
the elastic member (400) supports the vibration transmitting section (230) at an opposite side of the vibration transmitting section (230) from the touch panel (210).

**5.** The electronic device of any of claims 1 to 4, wherein the vibrating section (300) is a piezoelectric element.

**6.** The electronic device of any of claims 1 to 5, wherein the vibrating section (300) is disposed at a position closer to a central portion, than to ends, of the vibration transmitting section (230).

**7.** The electronic device of claim 1, wherein a resonant frequency of the spring-mass system vibration is adjusted by the mass of the weight piece (240, 251).

**8.** The electronic device of any of claims 1 to 5, wherein,
the support portion (220, 241, 252) couples the touch panel (210) and the vibration transmitting section (230) together; and
the vibration transmitting section (230) further comprises an arm (253) being fixed on the support portion (220, 241, 252) and supporting the weight piece (240, 251).

**9.** The electronic device of claim 8, wherein the vibrating section (300) is disposed on the arm (253).

**10.** The electronic device of any of claims 1 to 9, wherein the touch panel (210) is shaped to present a curved surface.

**11.** The electronic device of any of claims 1 to 10, further comprising a display section (700) to display an image.

**12.** The electronic device of any of claims 1 to 11, wherein the electronic device is a car navigation system.


**Patentansprüche**

**1.** Elektronische Vorrichtung (100) die umfasst:

einen berührungsempfindlichen Bildschirm (210);
einen Teilabschnitt (230) zum Übertragen von Vibrationen, der mit dem berührungsempfindlichen Bildschirm (210) in einem Abstand dazu gekoppelt ist;
einen Vibrier-Teilabschnitt (300), der den Teilabschnitt (230) zum Übertragen von Vibrationen vibrieren lässt;
ein elastisches Element (400), das den Teilabschnitt (230) zum Übertragen von Vibrationen elastisch lagert und in Reaktion auf Vibration des Teilabschnitts (230) zum Übertragen von Vibrationen vibrieren kann; sowie
einen Träger (500), der das elastische Element (400) trägt,
wobei das elastische Element (400) zwischen dem Teilabschnitt (230) zum Übertragen von Vibrationen und dem Träger (500) so angeordnet ist, dass der berührungsempfindliche Bildschirm (210) von dem elastischen Element (400) über den Teilabschnitt (230) zum Übertragen von Vibrationen gelagert wird,
die elektronische Vorrichtung des Weiteren einen Trageabschnitt (220, 241, 252) umfasst, der den berührungsempfindlichen Bildschirm (210) und den Teilabschnitt (230) zum Übertragen von Vibrationen miteinander koppelt,
und die elektronische Vorrichtung (100) **dadurch gekennzeichnet ist, dass** das elastische Element (400) Massen des berührungsempfindlichen Bildschirms (210), des Trageabschnitts, des Teilabschnitts (230) zum Übertragen von Vibrationen sowie des Vibrier-Teilabschnitts (300) trägt, und so ein Feder-Masse-System bildet,
wobei eine Resonanzfrequenz des Teilabschnitts (230) zum Übertragen von Vibrationen und eine Resonanzfrequenz des Feder-Masse-Systems gleich sind,
ein Gewicht-Teil (240, 251) an einer Position näher an einem Mittelabschnitt als an Enden des Teilabschnitts (230) zum Übertragen von Vibrationen angeordnet ist, und
das Gewicht-Teil (240) von einem Trageabschnitt (241) getragen wird und über den Trageabschnitt (241) mit dem Teilabschnitt (230) zum Übertragen von Vibrationen verbunden ist, wobei der Trageabschnitt (241) in einem Bereich mit dem Teilabschnitt (230) zum Übertragen von Vibrationen in Kontakt ist, der kleiner ist als ein Bereich, der von dem Gewicht-Teil (240, 251) an der Seite des Teilabschnitts zum Übertragen von Vibrationen eingenommen wird.

**2.** Elektronische Vorrichtung nach Anspruch 1, wobei Vibration des Teilabschnitts (230) zum Übertragen von Vibrationen sich zu dem elastischen Element (400) ausbreitet, das elastische Element (400) vibrieren lässt und bewirkt, dass der über das elastische Element (400) gelagerte berührungsempfindliche Bildschirm (210) vibriert.

**3.** Elektronische Vorrichtung nach Anspruch 1 oder 2, wobei eine Resonanzfrequenz des Teilabschnitts (230) zum Übertragen von Vibrationen 50 Hz bis 200 Hz beträgt.

**4.** Elektronische Vorrichtung nach einem der Ansprüche 1 bis 3, wobei
der Teilabschnitt (230) zum Übertragen von Vibrationen in dem Abstand zu dem berührungsempfindlichen Bildschirm (210) an einer Seite des berührungsempfindlichen Bildschirms (210) angeordnet ist, die einer zu berührenden Seite desselben gegenüberliegt; und
das elastische Element (400) den Teilabschnitt (230) zum Übertragen von Vibrationen an einer dem berührungsempfindlichen Bildschirm (210) gegenüberliegenden Seite des Teilabschnitts (230) zum Übertragen von Vibrationen lagert.

**5.** Elektronische Vorrichtung nach einem der Ansprüche 1 bis 4, wobei der Vibrier- Teilabschnitt (300) ein piezoelektrisches Element ist.

**6.** Elektronische Vorrichtung nach einem der Ansprüche 1 bis 5, wobei der Vibrier- Teilabschnitt (300) an einer Position näher an einem Mittelabschnitt als an Enden des Teilabschnitts (230) zum Übertragen von Vibrationen angeordnet ist.

**7.** Elektronische Vorrichtung nach Anspruch 1, wobei eine Resonanzfrequenz von Vibration des Feder-Masse-Systems durch die Masse des Gewicht-Teils (240, 251) reguliert wird.

**8.** Elektronische Vorrichtung nach einem der Ansprüche 1 bis 5, wobei
der Trageabschnitt (220, 241, 252) den berührungsempfindlichen Bildschirm (210) und den Teilabschnitt (230) zum Übertragen von Vibrationen miteinander koppelt; und
der Teilabschnitt (230) zum Übertragen von Vibrationen des Weiteren einen Arm (253) umfasst, der an dem Trageabschnitt (220, 241, 252) befestigt ist und das Gewicht-Teil (240, 251) trägt.

**9.** Elektronische Vorrichtung nach Anspruch 8, wobei der Vibrier-Teilabschnitt (300) an dem Arm (253) angeordnet ist.

**10.** Elektronische Vorrichtung nach einem der Ansprüche 1 bis 9, wobei der berührungsempfindliche Bildschirm (210) so geformt ist, dass er eine gekrümmte Oberfläche aufweist.

**11.** Elektronische Vorrichtung nach einem der Ansprüche 1 bis 10, die des Weiteren einen Anzeige-Teilabschnitt (700) zum Anzeigen eines Bildes umfasst.

**12.** Elektronische Vorrichtung nach einem der Ansprüche 1 bis 11, wobei die elektronische Vorrichtung ein Fahrzeug-Navigationssystem ist.

**Revendications**

**1.** Dispositif électronique (100) comprenant:

un panneau tactile (210);
une section de transmission de vibrations (230) couplée au panneau tactile (210) à un intervalle de celui-ci;
une section de vibrations (300) pour faire vibrer la section de transmission de vibrations (230);
un élément élastique (400) supportant élastiquement la section de transmission de vibrations (230) et capable de vibrer en réaction aux vibrations de la section de transmission de vibrations (230); et
une base (500) supportant le élément élastique (400),
dans lequel
l'élément élastique (400) est disposé entre la section de transmission de vibrations (230) et la base (500) de telle sorte que le panneau tactile (210) est supporté par l'élément élastique (400) par le biais de la section de transmission de vibrations (230),
le dispositif électronique comprenant en outre une partie support (220, 241, 252) couplant le panneau tactile (210) et la section de transmission de vibrations (230),

EP 3 086 207 B1

le dispositif électronique (100) étant **caractérisé en ce que**

l'élément élastique (400) porte des masses du panneau tactile (210), la partie de support, la section de transmission de vibrations (230) et la section de vibrations (300) établissant ainsi un système ressort-masse, une fréquence de résonance de la section de transmission de vibrations (230) et une fréquence de résonance des vibrations du système ressort-masse sont égales,

un contrepoids (240, 251) est disposé plus proche d'une partie centrale, plutôt que des extrémités, de la section de transmission de vibrations (230), et

le contrepoids (240) est supporté par une partie support (241) et relié à la section de transmission de vibrations (230) par le intermédiaire de la partie support (241), la partie support (241) est en contact avec la section de transmission de vibrations (230) dans une zone de superficie inférieure à une zone occupée par la contrepoids (240, 251) côté section de transmission de vibrations.

2. Dispositif électronique selon la revendication 1, dans lequel les vibrations de la section de transmission de vibrations (230) se propagent à l'élément élastique (400) pour faire vibrer l'élément élastique (400) de même que le panneau tactile (210) supporté par l'élément élastique (400).

3. Dispositif électronique selon les revendications 1 ou 2, dans lequel une fréquence de résonance de la section de transmission de vibrations (230) est de 50 Hz à 200 Hz.

4. Dispositif électronique selon l'une quelconque des revendications 1 à 3, dans lequel:

à l'intervalle du panneau tactile (210), la section de transmission de vibrations (230) est disposée sur un côté opposé du panneau tactile (210) à partir d'un côté de celui-ci à toucher;
et
l'élément élastique (400) supporte la section de transmission de vibrations (230) sur un côté opposé de la section de transmission de vibrations (230) à partir du panneau tactile (210).

5. Dispositif électronique selon l'une quelconque des revendications 1 à 4, dans lequel la section de vibrations (300) est un élément piézoélectrique.

6. Dispositif électronique selon l'une quelconque des revendications 1 à 5, dans lequel la section de vibrations (300) est disposée plus proche d'une partie centrale que des extrémités de la section de transmission de vibrations (230).

7. Dispositif électronique selon la revendication 1, dans lequel une fréquence de résonance des vibrations du système ressort-masse est réglée par la masse du contrepoids (240, 251).

8. Dispositif électronique selon l'une quelconque des revendications 1 à 5, dans lequel:

la partie support (220, 241, 252) couple le panneau tactile (210) et la section de transmission de vibrations (230); et
la section de transmission de vibrations (230) comprend en outre un bras (253) fixé sur la partie support (220, 241, 252) et supportant le contrepoids (240, 251).

9. Dispositif électronique selon la revendication 8, dans lequel la section de vibrations (300) est disposée sur le bras (253).

10. Dispositif électronique selon l'une quelconque des revendications 1 à 9, dans lequel le panneau tactile (210) est conçu pour présenter une surface courbe.

11. Dispositif électronique de l'une quelconque des revendications 1 à 10, comprenant en outre une section d'affichage (700) pour afficher une image.

12. Dispositif électronique de l'une quelconque des revendications 1 à 11, dans lequel le dispositif électronique est un système de navigation automobile.

*FIG.1*

*FIG.2*

FIG.3

(a)

300

(b)

230

300

(c)

230

300

(d)

230

300

FIG.4

(a)

(b)

*FIG.5*

## FIG.6

## FIG.7

## FIG.8

## FIG.9

FIG.10

**EP 3 086 207 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011057888 A1
- US 2011032091 A1
- US 2013229088 A1
- JP 4199416 A